# FASCICULE DE BREVET EUROPEEN

(11) **EP 1 151 904 B1**
(45) Date de publication et mention de la délivrance du brevet: **10.08.2005**
(21) Numéro de dépôt: 01400976.5
(22) Date de dépôt: 13.04.2001
(51) Int. Cl.: B61C 17/04, H02K 9/04

(54) **Dispositif et procédé de ventilation d'équipements électriques embarqués à bord d'un véhicule ferroviaire**
Vorrichtung und Verfahren zur Lüftung von elektrischen Geräten in einem Schienenfahrzeug
Device and method for ventilating of electrical equipment mounted in a railway vehicle

(30) Priorité: 04.05.2000 FR 0005746
(43) Date de publication de la demande: 07.11.2001
(73) Titulaire: ALSTOM, 92300 Levallois-Perret (FR)
(72) Inventeur: Lievremont, Gilles, 25290 Ornans (FR); Mary, Bernard, 25320 Montferrant le Château (FR)
(74) Mandataire: de Lambilly Delorme, Marie Pierre

(56) Documents cités:
- EP-A- 0 073 846
- DE-A- 3 231 152
- US-A- 4 831 294

## Description

L'invention se rapporte à un dispositif et à un procédé de ventilation d'équipements électriques embarqués à bord d'un véhicule ferroviaire alimenté en courant continu et plus particulièrement à un dispositif de ventilation comportant pour chacun des équipements électriques, un ventilateur associé commandé par un moteur électrique. Le dispositif de ventilation s'applique de préférence aux véhicules de traction ferroviaire pour lesquels les équipements électriques ventilés embarqués sont nombreux.

Habituellement, chaque équipement de puissance d'une motrice, tel que les transformateurs, les moteurs de traction, les rhéostats de freinage ou les blocs électroniques de puissance sont refroidis individuellement au moyen d'un ventilateur entraîné par un moteur électrique, l'ensemble de ces moteurs étant alimenté en électricité par un même convertisseur assurant la transformation, à bord de la motrice, du courant continu disponible à la caténaire en un courant alternatif adapté pour le fonctionnement des équipements de puissance. Toutefois, un tel dispositif de ventilation présente l'inconvénient d'entraîner un fonctionnement collectif des différents ventilateurs. Ainsi, dès l'instant qu'un seul des ventilateurs doit fonctionner à pleine puissance, pour assurer le refroidissement de l'équipement électrique qui lui est associé, les autres ventilateurs sont également alimentés à pleine puissance par le convertisseur, ce qui conduit à augmenter inutilement la consommation d'énergie et à générer des nuisances sonores supplémentaires.

Le but de la présente invention est donc de proposer un procédé de ventilation d'équipements électriques embarqués à bord d'un véhicule ferroviaire et un véhicule ferroviaire équipé d'un dispositif de ventilation, qui procure un confort accru au véhicule ferroviaire en diminuant les nuisances sonores et qui assure une consommation d'énergie réduite.

L'invention a pour objet un véhicule ferroviaire équipé d'un dispositif de ventilation pour des équipements électriques embarqués à son bord, ce dernier étant alimenté en courant continu soit directement par un système capteur de courant relié à une source de courant continu, soit indirectement par redressage et filtrage d'un courant capté par un système capteur de courant relié à une source de courant alternatif monophasé, chaque équipement électrique étant ventilé au moyen d'un ventilateur de refroidissement commandé par un moteur électrique, caractérisé en ce que les moteurs électriques sont des moteurs asynchrones, chaque moteur électrique de ventilateur étant alimenté en courant alternatif triphasé de façon indépendante par un convertisseur individuel relié au courant continu d'alimentation du véhicule ferroviaire.

Le véhicule équipé du dispositif de ventilation d'équipements électriques embarqués conforme à l'invention peut en outre comporter une ou plusieurs des caractéristiques suivantes, prises isolément ou selon toutes les combinaisons techniquement possibles :
- le convertisseur individuel est intégré sur le bâti du moteur de ventilateur ;
- chaque convertisseur d'alimentation des ventilateurs est piloté en fonction de la puissance consommée par l'équipement électrique associé ;
- le véhicule ferroviaire est une motrice comportant des équipements électriques de puissance tels que des transformateurs, des moteurs de traction, des rhéostats de freinage ou des blocs électronique de puissance.

L'invention concerne également un procédé de ventilation d'équipements électriques embarqués à bord d'un véhicule ferroviaire alimenté en courant continu, chacun des équipements électriques étant ventilé au moyen d'un ventilateur de refroidissement commandé par un moteur électrique, caractérisé en ce que chaque moteur électrique de ventilateur est alimenté en courant alternatif triphasé de façon indépendante au moyen d'un convertisseur individuel relié au courant continu d'alimentation du véhicule ferroviaire, le convertisseur étant piloté en fonction de la puissance consommée par l'équipement électrique associé ;

Selon une autre caractéristique du procédé selon l'invention, chaque convertisseur est piloté de façon à ce que le refroidissement de l'équipement électrique associé soit proportionnel à la puissance consommée par l'équipement électrique.

On comprendra mieux les buts, aspects et avantages de la présente invention, d'après la description donnée ci-après d'un mode de réalisation de l'invention, présenté à titre d'exemple non limitatif, en se référant aux dessins annexés, dans lesquels :
- la figure 1 est une représentation schématique en vue de côté d'un véhicule ferroviaire muni d'un dispositif de ventilation d'équipements électriques embarqués selon l'invention ;
- la figure 2 est une vue en perspective d'un moteur de ventilation intégrant un convertisseur utilisé dans le dispositif de ventilation selon l'invention .

Pour faciliter la lecture du dessin, seuls les éléments nécessaires à la compréhension de l'invention ont été représentés.

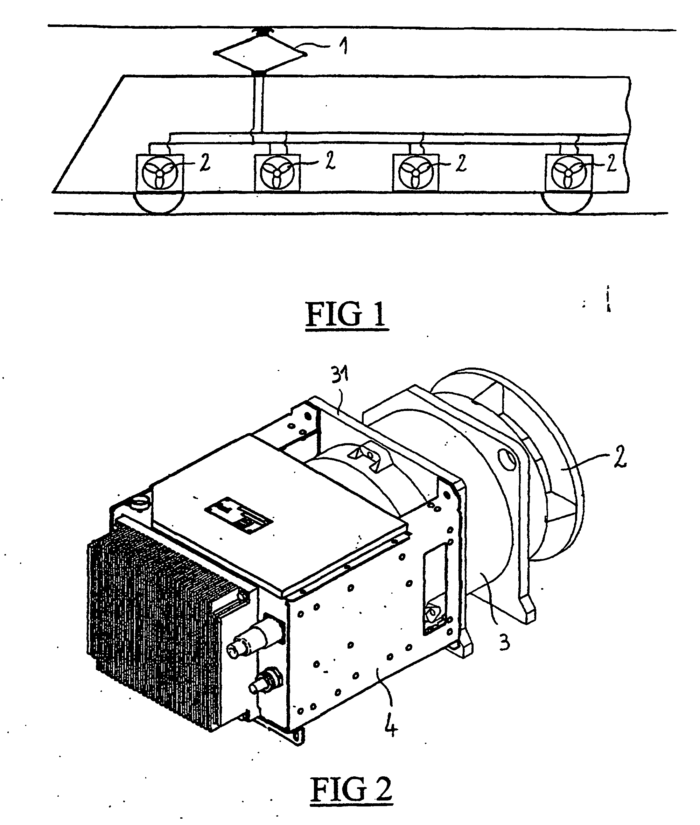

La figure 1 représente une motrice de véhicule ferroviaire alimentée en énergie électrique au moyen d'un appareil à pantographe 1 relié à une caténaire fournissant du courant continu sous une tension 750V.

Conformément à la figure 1, la motrice est équipée d'équipements électriques du type moteur de traction, transformateur, bloc électronique de puissance ou rhéostat de freinage, comportant chacun un ventilateur 2 de refroidissement entraîné en rotation par un moteur électrique 3 asynchrone .

Conformément à la figure 2, un convertisseur de courant 4 est intégré au bâti de chaque moteur 3 asynchrone de manière à assurer la transformation du courant continu 750V de caténaire en un courant alternatif triphasé alimentant le moteur 3 asynchrone. Le convertisseur 4 est fixé par des vis sur une collerette 31 du bâti du moteur électrique 3 permettant ainsi d'obtenir un ensemble convertisseur 4 - moteur 3 - ventilateur 2 peut encombrant.

Le convertisseur de courant 4 est composé d'IGBT et assure une fréquence f de sortie du convertisseur modulable, avec un rapport Uₛₒᵣₜᵢₑ/fₛₒᵣₜᵢₑ constant, jusqu'à une tension de sortie fondamentale Uₛₒᵣₜᵢₑ=545V pour une fréquence fₛₒᵣₜᵢₑ=50Hz. Le bobinage de chaque moteur électrique 3 est dimensionné pour fonctionner directement à la tension de sortie fondamentale des convertisseurs soit 545V/50Hz.

Chaque convertisseur 4 comporte un circuit de commande recevant, en tant que paramètre d'entrée, la valeur du courant consommé par l'équipement électrique à ventiler.

Le fonctionnement du dispositif de ventilation selon l'invention est le suivant :

Lorsqu'un équipement électrique est en fonctionnement, le moteur 3 du ventilateur 2 de refroidissement qui lui est associé est alimenté en courant alternatif par le convertisseur 4 intégré, ce dernier se basant sur la lecture du courant consommé par l'équipement électrique pour alimenter proportionnellement le moteur électrique 3 afin que la vitesse de rotation du ventilateur 2 soit proportionnelle à la consommation de l'équipement électrique associé.

Un tel dispositif de ventilation comportant des moteurs asynchrones pour l'entraînement des ventilateurs présente l'avantage d'avoir une durée de vie et une fiabilité supérieure aux dispositifs comportant des moteurs à courant continu tout en nécessitant une maintenance moindre. Par ailleurs, la présence d'un convertisseur intégré à chaque moteur de ventilateur permet de moduler individuellement la puissance de chaque ventilateur en fonction de la puissance électrique consommée par l'équipement électrique et donc de la chaleur dégagée par ce dernier.

En conséquence, le dispositif de ventilation selon l'invention permet d'adapter la ventilation de chaque équipement électrique en fonction des besoins de refroidissement et permet ainsi de réduire considérablement la consommation d'énergie. Par ailleurs, le dispositif et le procédé de ventilation selon l'invention présentent également l'avantage, en permettant le pilotage individuel des ventilateurs des équipements électriques, de limiter le temps de fonctionnement des ventilateurs réduisant ainsi les nuisances sonores émises par ces derniers et procurant donc un plus grand confort pour les passagers.

## Revendications

1. véhicule ferroviaire équipé d'un dispositif de ventilation pour des équipements électriques embarqués à son bord, ledit véhicule ferroviaire étant alimenté en courant continu soit directement par un système capteur de courant (1) relié à une source de courant continu, soit indirectement par redressage et filtrage d'un courant capté par un système capteur de courant (1) relié à une source de courant alternatif monophasé, chaque équipement électrique étant ventilé au moyen d'un ventilateur de refroidissement (2) commandé par un moteur électrique (3), **caractérisé en ce que** les moteurs électriques (3) sont des moteurs asynchrones, chaque moteur électrique (3) de ventilateur (2) étant alimenté en courant alternatif triphasé de façon indépendante par un convertisseur individuel (4) relié au courant continu d'alimentation du véhicule ferroviaire.

2. Véhicule ferroviaire selon la revendication 1, **caractérisé en ce que** ledit convertisseur individuel (4) est intégré sur le bâti dudit moteur de ventilateur (2).

3. Véhicule ferroviaire selon la revendication 2, **caractérisé en ce que** chaque convertisseur d'alimentation des ventilateurs (2) est piloté en fonction de la puissance consommée par ledit équipement électrique associé.

4. Véhicule ferroviaire selon l'une quelconque des revendications 1 à 3, **caractérisé en ce que** ledit véhicule ferroviaire est une motrice comportant des équipements électriques de puissance tels que des transformateurs, des moteurs de traction, des rhéostats de freinage ou des blocs électronique de puissance.

5. Procédé de ventilation d'équipements électriques embarqués à bord d'un véhicule ferroviaire alimenté en courant continu, chacun desdits équipements électriques étant ventilés au moyen d'un ventilateur de refroidissement (2) commandé par un moteur électrique (3), **caractérisé en ce que** les moteurs électriques (3) sont des moteurs asynchrones, chaque moteur électrique (3) de ventilateur (2) étant alimenté en courant alternatif triphasé de façon indépendante au moyen d'un convertisseur individuel relié au courant continu d'alimentation du véhicule ferroviaire, ledit convertisseur (4) individuel étant piloté en fonction de la puissance consommée par l'équipement électrique associé.

6. Procédé de ventilation selon la revendication précédente, **caractérisé en ce que** chaque convertisseur est piloté de façon à ce que le refroidissement de l'équipement électrique associé soit proportionnel à la puissance consommée par ledit équipement électrique.

## Patentansprüche

1. Schienenfahrzeug, welches mit einer Lüftungsvorrichtung für elektrische Geräte ausgestattet ist, die sich an Bord des Schienenfahrzeugs befinden, wobei das Schienenfahrzeug mit Gleichstrom gespeist wird, entweder direkt durch ein mit einer Gleichstromquelle verbundenes Stromaufnehmersystem (1) oder indirekt durch Richten und Filtern eines Stroms, der von einem mit einer Einphasenwechselstromquelle verbundenen Stromaufnehmersystem (1) aufgenommen wird, wobei jedes elektrische Gerät mittels einem Lüfter (2) zur Kühlung belüftet wird, der von einem Elektromotor (3) angetrieben wird, **dadurch gekennzeichnet, dass** die Elektromotoren (3) Asynchronmotoren sind, wobei jeder Elektromotor (3) des Lüfters (2) unabhängig mit Dreiphasenwechselstrom gespeist wird von einem einzelnen Umformer (4), der mit Gleichstrom zur Speisung des Schienenfahrzeugs verbunden ist.

2. Schienenfahrzeug gemäss Anspruch 1, **dadurch gekennzeichnet, dass** jeder einzelne Umformer (4) auf dem Rahmen des Motors des Lüfters (2) eingebaut ist.

3. Schienenfahrzeug gemäss Anspruch 2, **dadurch gekennzeichnet, dass** jeder Umformer zur Speisung der Ventilatoren (2) abhängig von der Leistung, die von dem verbundenen elektrischen Gerät verbraucht wird, geregelt wird.

4. Schienenfahrzeug gemäss einem der Ansprüche 1 bis 3, **dadurch gekennzeichnet, dass** das Schienenfahrzeug ein Triebwagen ist, welcher elektrische Leistungsgeräte aufweist wie Transformatoren, Triebmotoren, Bremskraftregler oder elektronische Leistungsblöcke.

5. Verfahren zur Lüftung von elektrischen Geräten, die sich an Bord eines Schienenfahrzeugs befinden, das mit Gleichstrom versorgt wird, wobei jedes der elektrischen Geräte mittels einem Lüfter zur Kühlung (2) belüftet wird, der von einem Elektromotor (3) angetrieben wird, **dadurch gekennzeichnet, dass** die Elektromotoren (3) Asynchronmotoren sind, jeder Elektromotor (3) des Lüfters (2) unabhängig mit Dreiphasenwechselstrom gespeist wird mittels einem einzelnen Umformer, der mit der Gleichstromspeisung des Schienenfahrzeugs verbunden ist, wobei der einzelne Umformer (4) abhängig von der Leistung geregelt wird, die von dem verbundenen elektrischen Gerät verbraucht wird

6. Verfahren zur Lüftung gemäß dem vorausgegangenen Anspruch, **dadurch gekennzeichnet, dass** jeder Umformer so geregelt wird, dass das Kühlen des verbundenen elektrischen Geräts proportional zur Leistung ist, die von dem elektrischen Gerät verbraucht wird.

## Claims

1. A rail vehicle fitted with ventilation apparatus for ventilating on-board electrical equipment, said rail vehicle being powered with DC either directly by an electricity pick-up system (1) connected to a DC source, or indirectly by rectifying and filtering electricity picked up by an electricity pick-up system (1) connected to a single-phase AC source, each piece of electrical equipment being ventilated by means of a respective cooling fan (2) controlled by an electric motor (3), the apparatus being **characterized in that** the electric motors (3) are asynchronous motors, each fan electric motor (3) being independently powered with three-phase AC by an individual converter (4) connected to the DC for powering the rail vehicle.

2. A rail vehicle according to claim 1, **characterized in that** said individual converter (4) is integrated on the stand of the motor of said fan (2).

3. A rail vehicle according to claim 2, **characterized in that** each fan power converter is controlled as a function of the power consumed by said associated electrical equipment.

4. A rail vehicle according to any one of claims 1 to 3, **characterized in that** said rail vehicle is a car including electrical power equipment such as transformers, traction motors, braking rheostats, and electronic power units.

5. A method of ventilating electrical equipment on board a DC-powered rail vehicle, each piece of said electrical equipment being ventilated by means of a respective cooling fan (2) controlled by an electric motor (3), the method being **characterized in that** the electric motors (3) are asynchronous motors, each fan electric motor (3) being independently powered with three-phase AC by means of an individual converter connected to the DC for powering the rail vehicle, said individual converter (4) being controlled as a function of the power consumed by the associated electrical equipment.

6. A ventilation method according to the preceding claim, **characterized in that** each converter is controlled so that cooling of the associated electrical equipment is proportional to the power consumed by said electrical equipment.
